# EUROPEAN PATENT SPECIFICATION

(11) **EP 0 378 995 B1**
(45) Date of publication and mention of the grant of the patent: **18.08.1993**
(21) Application number: 90100110.7
(22) Date of filing: 04.01.1990
(51) Int. Cl.: C30B 25/00, C30B 29/16, C30B 29/60, C04B 35/65, C01G 9/02

(54) **Method of producing zinc oxide whiskers**
Verfahren zur Herstellung von Zinkoxid-Whiskern
Procédé de production de trichites de l'oxyde de zinc

(30) Priority: 18.01.1989 JP 10742/89; 18.01.1989 JP 10743/89
(43) Date of publication of application: 25.07.1990
(73) Proprietor: MATSUSHITA ELECTRIC INDUSTRIAL CO., LTD., Kadoma-shi, Osaka-fu, 571 (JP); Chugai Ro Co., Ltd., Osaka-shi Osaka-fu (JP)
(72) Inventor: Yoshinaka, Minoru, Higashiosaka-shi Osaka-fu (JP); Miyoshi, Ichiro, Nara-shi, Nara-ken (JP); Asakura, Eizo, Suita-shi, Osaka-fu (JP); Shintaku, Yasayuki, Sennan-shi, Osaka-fu (JP); Yoshida, Hideyuki, Amagasaki-shi, Hyogo-ken (JP)
(74) Representative: Eisenführ, Speiser & Partner

(56) References cited:
- EP-A- 0 325 797
- US-A- 2 200 873
- US-A- 2 267 720
- US-A- 2 331 599
- JOURNAL OF APPLIED PHYSICS, vol. 42, no. 13, December 1971, New York, NY, US; S.D.SHARMA et al.: "Growth of ZnO whiskers, platelets, and dendrites", pp. 5302-5304
- CHEMICAL ABSTRACTS, vol. 101, no. 6, August 1984, Columbus, Ohio, US; SAKURAI et al.: "Formation of needle-like zinc oxide particles and the analysis of particle morphology", p. 117
- PATENT ABSTRACTS OF JAPAN, vol. 10, no. 280 (C-374)[2336], 24 September 1986; & JP - A - 61 101 499
- COMPTES RENDUS HEBDOMADAIRES DES SEANCES DE L'ACADEMIE DES SCIENCES, vol. 270, series B, 12 January 1970, Paris (FR); M.A.BILLMAN et al.: "Croissance en phase vapeur de monocristaux d'oxyde de zinc", pp. 170-173

## Description

The present invention relates to a method of producing zinc oxide whiskers according to the pre-characterizing part of the claim.

Zinc oxide whiskers are widely used, for example, as a reinforcement material for various components, a material for electronic components or the like.

The Japanese Patent Laid-open Application No. 50-6597 discloses a method of producing zinc oxide whiskers, in which a zinc alloy or a fixture of zinc and a metal such as copper, aluminum, tin, lead or the like having a boiling point higher than that of zinc is initially put into a container, for example, a Tamman tube. The container is then introduced into a heating furnace and heated up to a temperature of 900-1400 °C in an atmosphere containing oxygen so that zinc vapor may be generated. The vapor is brought into contact with oxygen contained in the atmosphere to produce zinc oxide whiskers on a substrate material of an alumina sintered compact, mullite sintered compact or the like. In this way, needle-like zinc oxide is obtained using this method.

The Japanese Patent Publication No. 60-5529 discloses another method, in which metallic zinc is initially accommodated in an internal cylinder disposed inside an external cylinder. Subsequently, the internal cylinder is filled with inert carrier gas such as nitrogen gas, argon gas or the like, and zinc vapor is generated by heating the metallic zinc. The generated zinc vapor is introduced into the external cylinder accommodating an oxygen-containing atmosphere by the carrier gas so that the zinc may be oxidized. Immediately after this process, the generated zinc oxide is turned into needle-like zinc oxide by rapidly cooling the zinc oxide at a cooling rate more than 480 °C/sec by the use of cooling air.

However, the method of the former requires a substrate material for whisker production and is, therefore, not suitable for continuous whisker production. This method further requires a metal having a boiling point higher than that of zinc.

The method of the latter requires the steps of heating a metallic zinc to generate zinc vapor, oxidizing the zinc vapor and rapidly cooling zinc oxide at a cooling rate more than 480 °C/sec.

Furthermore, the needle-like zinc oxide produced in these methods is small and not uniform in configuration.

It is the object of the present invention to substantially eliminate the above described disadvantages inherent in the prior art method of producing zinc oxide whiskers and to provide an improved method of effectively mass-producing zinc oxide whiskers each substantially in the form of a tetrapod from a raw material which is readily available.

An aspect of this object is to provide a method of the above described type capable of producing the zinc oxide whiskers which are relatively large and uniform in configuration.

These objects are attained by a method according to the claim.

The size of zinc powder particles to be used in the present invention is 1-500 µm. N₂ gas, Ar gas, combustion gas containing no oxygen, or the like is employed as the inert gas. The zinc powder is heated up to a temperature more than 908 °C, preferably more than approximately 950 °C so that zinc vapor may be satisfactorily generated.

The zinc vapor is then brought into contact with oxygen gas or oxygen-containing gas by introducing the zinc vapor into an oxygen-containing atmosphere or by blowing the oxygen gas or oxygen-containing gas in the zinc vapor. Air is generally used as the oxygen-containing gas.

The amount of supply of the oxygen gas or oxygen-containing gas is in proportion to that of raw material.

The zinc oxide whiskers produced during oxidization can be caused to further grow by keeping them at a temperature more than 908 °C, preferably more than approximately 950 °C for a relatively short period of time.

According to the present invention, since the zinc powder particles coated with oxide layers are heated in an inert gas, not only the growth of the oxide layers is restricted but solid zinc or liquid zinc is purely held inside the oxide layers. Thereafter, zinc vapor is generated, which turns into zinc oxide whiskers after oxidization thereof.

These and other objects and features of the present invention will become more apparent from the following description taken in conjunction with the preferred embodiment thereof with reference to the accompanying drawings, throughout which like parts are designated by like reference numerals, and wherein;
Fig. 1 is a schematic sectional view of an apparatus for continuously producing zinc oxide whiskers using a method according to the present invention;
Fig. 2 is a view similar to Fig. 1, which particularly shows a modification thereof;
Fig. 3 is a schematic sectional view of a batch type apparatus for effecting the method according to the present invention; and
Figs. 4 and 5 are electron micrographs indicative of the crystal structure of the zinc oxide whiskers obtained by the method according to the present invention.

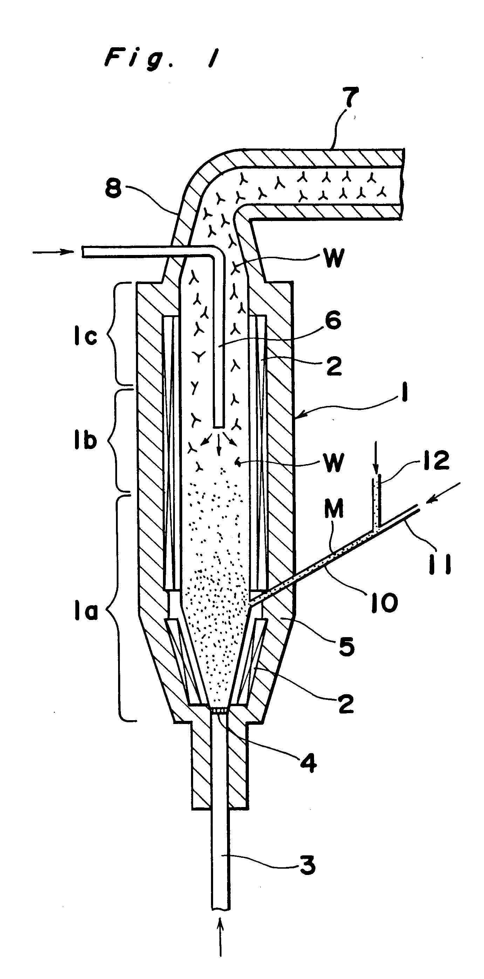

Referring now to the drawings, there is shown in Fig. 1, an apparatus for continuously producing zinc oxide whiskers, which is provided with a cylindrical fluidized bed furnace 1. The furnace 1 is comprised of a fluidized bed portion or heating portion 1a for heating zinc powder particles coated with oxide layers, an oxidizing portion 1b for producing zinc oxide whiskers by bringing zinc vapor into contact with oxygen gas or oxygen-containing gas and a free board portion 1c for causing the zinc oxide whiskers to grow.

The furnace 1 is provided at its lower end with an inert gas supply pipe 3 having an upper open end, on which a dispersion plate 4 is mounted for supplying inert gas to be used for fluidization into the furnace 1 at a uniform rate. The inert gas is, for example, of combustion gas containing no oxygen and having a temperature of approximately 1000 °C. N₂ gas or Ar gas having this temperature may be used as the inert gas. However, such gas may be supplied after being heated up to a temperature lower than the aforementioned temperature or without being heated.

A supply pipe 10 for supplying both carrier gas and a raw material into the furnace 1 is securely mounted on a side wall 5 of the fluidized bed portion 1a of the furnace 1. A carrier gas supply pipe 11 and a raw material supply pipe 12 are connected to the supply pipe 10. In this embodiment, N₂ gas is used as the carrier gas.

An oxygen-containing gas supply pipe 6 extends through an upper end portion 8 of the furnace 1 and has an open end directed towards the oxidizing portion 1b for producing the zinc oxide whiskers.

The upper end portion 8 of the furnace 1 is connected to a duct 7, which is further connected to a collector (not shown). The collector is provided with a suction fan and a filter for capturing whiskers contained in the gas drawn by the suction fan.

The method of producing zinc oxide whiskers according to the present invention may be carried out as follows in the apparatus having the above described construction.

Combustion gas having a temperature of approximately 1000 °C is supplied into the furnace 1 through the inert gas supply pipe 3 and the dispersion plate 4.

On the other hand, N₂ gas employed as the carrier gas is supplied through the pipe 11, thereby carrying a raw material M supplied from the pipe 12 into the fluidized bed portion 1a of the furnace 1 through the pipe 10.

In this embodiment, zinc powder is employed as the raw material M and consists of particles coated with oxide layers and having a diameter of 1 to 500 µm. In this way, the zinc powder M is fluidized by the combustion gas. During the fluidization, the zinc powder is heated up to a temperature more than 908 °C, preferably more than approximately 950 °C and turned into zinc vapor, which ascends towards the oxidizing portion 1b.

Oxygen-containing gas such as air is introduced into the oxidizing portion 1b of the furnace 1 through the pipe 6. Accordingly, the ascending zinc vapor is brought into contact with and oxidized by the air, resulting in the production of zinc oxide whiskers W.

The produced zinc oxide whiskers W are moved to the free board portion 1c provided at an upper portion of the furnace 1. The whiskers W further grow while being held in the free board portion 1c for a relatively short period of time. This process can be carried out in the duct 7, in which the whiskers W generated during the oxidization flows along with the gas towards the collector.

The atmosphere temperature in the fluidized bed portion 1a, oxidizing portion 1b and free board portion 1c is kept at a temperature at least more than 908 °C, preferably more than approximately 950 °C by heaters 2 provided in the furnace 1.

The zinc oxide whiskers W reach the upper end of the furnace 1 and are successively collected by the collector through the duct 7.

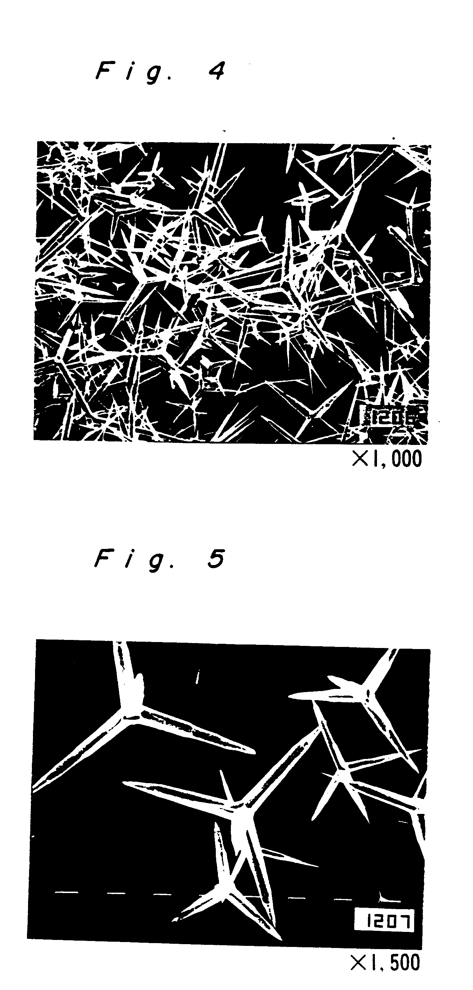

Figs. 4 and 5 are electron micrographs indicative of the crystal structure of the zinc oxide whiskers W obtained in this way. As shown in Figs. 4 and 5, the zinc oxide whiskers W are needle-like whiskers substantially in the form of a tetrapod and each of them has a nuclear portion having a diameter of 0.7-14 µm and four needle portions having a length of 3-300 µm.

For comparison, an experiment was made using oxygen-containing gas such as air in place of combustion gas employed as the inert gas. Other conditions are the same as those of the foregoing embodiment. In this experiment, zinc oxide powder particles were produced and any zinc oxide whiskers in the form of a tetrapod was not obtained.

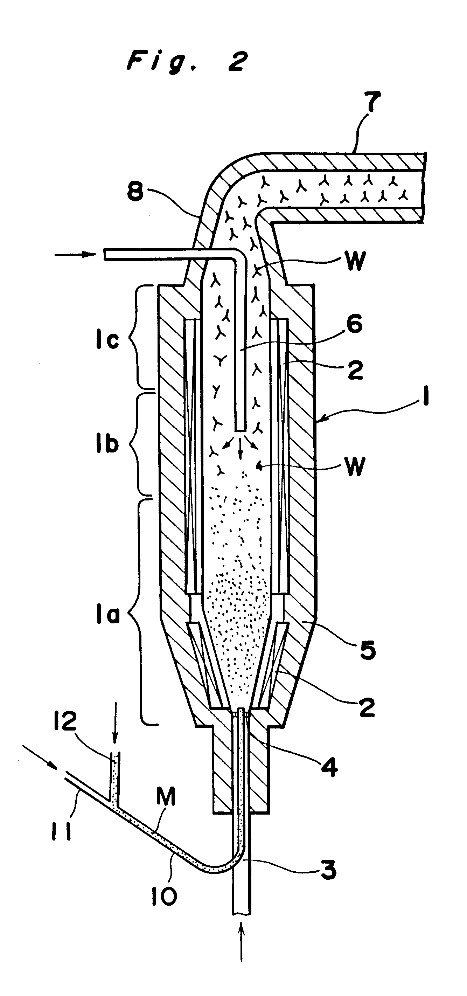

Fig. 2 is a modification of the apparatus of Fig. 1.

As shown in Fig. 2, the supply pipe 10 for supplying both carrier gas and a raw material may be provided at the lower end of the furnace 1 so as to extend through the inert gas supply pipe 3 and the dispersion plate 4.

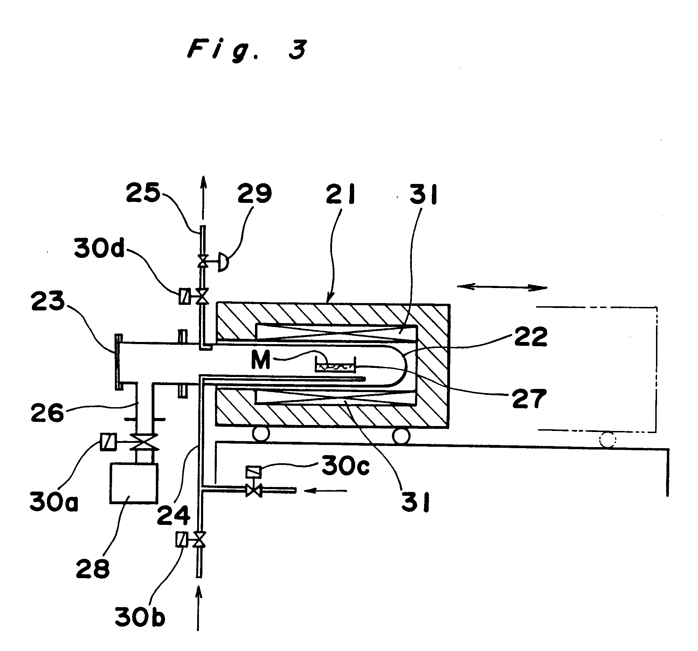

Fig. 3 depicts a batch type apparatus for effecting the method according to the present invention. The apparatus is provided with a horizontally movable heating furnace 21 and a fixed muffle tube 22. The muffle tube 22 has a closed end located inside the furnace 21 and an opposite open end located outside the furnace 21. A door 23 is detachably mounted on the open end of the muffle tube 22. The muffle tube 22 is provided with a gas supply tube 24 communicating with an inert gas supply source via a valve 30b and an oxygen gas or oxygen-containing gas source via a valve 30c, with an exhaust tube 25 for exhausting atmosphere inside the muffle tube 22, and also with an evacuation tube 26 for evacuating the muffle tube 22. The muffle tube 22 accommodates a tray 27 containing zinc powder. The evacuation tube 26 communicates with a vacuum pump 28 via a valve 30a. A pressure control valve 29 and a valve 30d are provided midway of the exhaust tube 25.

In the above described construction, the door 23 is initially opened and the tray 27 containing zinc powder particles M coated with oxide layers is inserted into the muffle tube 22. The door 23 is then closed. Thereafter, the valves 30b, 30c and 30d are closed while the valve 30a is opened and the vacuum pump 28 is operated so that the muffle tube 22 may be evacuated. After the valve 30a is closed, the valves 30b and 30d are opened and the N₂ gas employed as the inert gas is supplied into the muffle tube 22 through the supply tube 24 so that the muffle tube 22 may be filled with inert gas. Thereafter, the furnace 21, which has been heated up to a temperature of approximately 1000 °C by heaters 31 disposed therein, is moved along the muffle tube 22 so as to cover it. The zinc powder contained in the tray 27 is then rapidly heated up in an atmosphere of inert gas. The zinc powder is heated for a predetermined period of time and turns to zinc vapor, with which the muffle tube 22 is filled. Under such conditions in which the N₂ gas is still held in the muffle tube 22, air is supplied into the muffle tube 22 from the supply tube 24 by opening the valve 30c so that oxygen may be blown into the zinc vapor. In this way, the zinc vapor is brought into contact with air and subjected to oxidization, thus resulting in the production of zinc oxide whiskers in the muffle tube 22. During the heating, since the volume of the N₂ gas in the muffle tube 22 increases with the temperature rise, the internal pressure of the muffle tube 22 tends to increase. In this furnace 21, however, the internal pressure of the muffle tube 22 is kept at a predetermined value by exhausting the N₂ gas contained in the muffle tube 22 through the pressure control valve 29. Similarly, during the oxidization, the internal pressure of the muffle tube 22 is also kept at the predetermined value by exhausting air contained in the muffle tube 22 through the pressure control valve 29.

It is noted that the zinc oxide whiskers obtained in this way are substantially the same as those obtained in the continuous type apparatus.

According to the present invention, zinc powder particles coated with oxide layers are used as a raw material and heated in the atmosphere of inert gas until the particles turn to zinc vapor. When the particles have turned to zinc vapor, the oxygen-containing gas is supplied thereto. Since these facts result in the production of zinc oxide whiskers during the short oxidization and the growth thereof, neither a substrate material for promoting the growth of zinc oxide whiskers nor the management for rapid cooling is required. Therefore, not only the whiskers can be readily produced but the growth of the oxide layers formed on the zinc powder is restricted. Furthermore, zinc is purely held inside the layers and never fail to turn to zinc vapor, thus resulting in the improvement in productivity of whiskers.

The zinc oxide whiskers obtained by the method of the present invention are relatively large and substantially in the form of a uniform tetrapod, as compared with those obtained by the conventional method.

When zinc powder is heated in an inert.gas fluidized bed, the zinc oxide whiskers can be continuously produced with ease. Since the zinc powder employed as a raw material is fluidized in the fluidized bed, the zinc powder is uniformly rapidly heated and zinc vapor corresponding to the amount of zinc powder can be assuredly obtained. Accordingly, the zinc oxide whiskers can be readily effectively mass-produced. In addition, since the produced whiskers are introduced along with a flow of gas to a predetermined location, they are hard to adhere to the inside of a furnace wall. Even if the whiskers adhere to the inside of the furnace wall, the amount thereof is negligibly small. Because of this, the whiskers can be effectively collected.

## Claims

1. A method of producing zinc oxide whiskers (W) each having a nuclear portion and four needle-like crystal portions extending from said nuclear portion in different four directions, the method comprising generating zinc vapor in an inert gas and oxidizing said zinc vapor,
**characterized by**
successively supplying zinc powder particles (M) coated with oxide layers into a fluidized bed furnace (1) which is kept at a predetermined temperature;
fluidizing the zinc powder particles (M) in an inert gas and generating zinc vapor by heating said particles;
successively supplying oxygen gas or oxygen-containing gas to the zinc vapor in the fluidized bed furnace (1) for oxidation of the zinc vapor; and
successively introducing said zinc oxide whiskers (W) along with the flow of gas to a predetermined location.

## Patentansprüche

1. Verfahren zum Herstellen von Zinkoxid-Whiskern (W), von denen jeder einen Kernbereich und vier nadelartige Kristallbereiche aufweist, die sich vom Kernbereich in vier unterschiedliche Richtungen erstrecken, wobei man bei dem Verfahren Zinkdampf in einem Inertgas erzeugt und den Zinkdampf oxidiert,
**dadurch gekennzeichnet,** daß man
mit Oxidschichten beschichtete Zinkpulver-Teilchen (M) fortlaufend einem Wirbelbettbrennofen (1) zuführt, der bei vorbestimmter Temperatur gehalten wird;
die Zinkpulver-Teilchen (M) in einem Inertgas verwirbelt und durch Erhitzen dieser Teilchen Zinkstaub erzeugt;
dem Zinkstaub im Wirbelbettbrennofen (1) zur Oxidation des Zinkstaubs fortlaufend Sauerstoffgas oder Sauerstoff enthaltendes Gas zuführt; und
die Zinkoxid-Whisker (W) zusammen mit dem Fluß des Gases zu einem vorbestimmten Ort führt.

## Revendications

1. Une méthode de production de trichites d'oxyde de zinc (W) qui ont chacun une portion formant un noyau et 4 portions cristallines en forme d'aiguille qui s'étendent à partir de ladite portion formant un noyau dans quatre directions différentes, la méthode comprenant la génération de vapeur de zinc dans un gaz inerte et l'oxydation de ladite vapeur de zinc,
caractérisée par
- la fourniture successive de particules de poudre de zinc (M) enrobées de couches d'oxyde dans un four à lit fluidisé qui est maintenu à une température pré-déterminée;
- la fluidisation des particules de poudre de zinc (M) dans un gaz inerte et la génération de vapeur de zinc par chauffage desdites particules;
- la fourniture successive de gaz d'oxygène ou de gaz contenant de l'oxygène à la vapeur de zinc dans le four à lit fluidisé (1) pour l'oxydation de la vapeur de zinc;
- l'introduction successive desdites trichites (W) accompagnant l'écoulement de gaz jusqu'à une position pré-déterminée.
